(19) Europäisches Patentamt / European Patent Office / Office européen des brevets

(11) **EP 3 323 665 B1**

(12) **EUROPEAN PATENT SPECIFICATION**

(45) Date of publication and mention
of the grant of the patent:
**10.07.2019  Bulletin 2019/28**

(51) Int Cl.:
**B60L 58/22** *(2019.01)*

(21) Application number: **16382538.3**

(22) Date of filing: **18.11.2016**

(54) **A BATTERY PACK BALANCING SYSTEM AND METHOD**

BATTERIEPACKAUSGLEICHSSYSTEM UND -VERFAHREN

SYSTÈME ET PROCÉDÉ POUR L'ÉQUILIBRAGE D'UN BLOC-BATTERIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**23.05.2018  Bulletin 2018/21**

(73) Proprietor: **Fico Triad, S.A.
08028 Barcelona (ES)**

(72) Inventors:
• **Sala Masip, Enric
08028 Barcelona (ES)**
• **Torné Albert, Adrià
08028 Barcelona (ES)**

(74) Representative: **Elzaburu S.L.P.
Miguel Angel 21, 2nd floor
28010 Madrid (ES)**

(56) References cited:
**FR-A1- 2 998 729    US-A1- 2014 217 982**

**Description**

**FIELD OF THE INVENTION**

The invention is related to a battery pack system and method which is intended for being provided to an electric vehicle, meaning electric also hybrid vehicle. The invention is directed to a system and a method of balancing battery cells.

**BACKGROUND OF THE INVENTION**

A great of effort has been made to develop electric vehicles or hybrid vehicles in recent years.

Rechargeable batteries have been developed. Said rechargeable batteries are connected in series to implement a large-capacity rechargeable battery, in order to be used in apparatuses requiring a large amount of power for operating a motor, such as the electric vehicles.

As described above, in electric vehicles, large-capacity rechargeable battery packs are installed. Said battery packs are commonly composed of a plurality of rechargeable battery cells connected in series. In the battery pack, several of rechargeable battery cells are alternately charged and discharged, such that it is required to manage the battery cells such that they maintain appropriate operation by controlling the charging and discharging.

For this purpose, a BMS (Battery Management System) that manages the general states of the battery is usually provided. The BMS detects voltage, current, temperature, etc. of the battery cells and controls the state of charge.

Thus, the existing management systems include a battery pack formed by battery unit cells, a battery management system disposed apart or included in the battery pack, being each battery cell connected with the battery management system. Therefore, each battery cell is connected by electrical wires, such that information on the unit cells is sensed and the operation is controlled. The electrical wire harness become necessarily important because voltage drops due to the electrical wire resistance can influence in the accuracy of the measurement.

It is important to prevent deterioration of the battery cells in a vehicle that uses the battery pack for an extended period of time, and thus a cell balancing is performed to minimize voltage deviations produced among the battery cells to prevent the battery pack deterioration. In the cell balancing, a passive balancing is mainly used, in which a resistance is connected in parallel with the overcharged cell that discharges said cell to consume capacity, thereby lowering voltage. Consumption current/power of the discharging resistance, required for balancing the cells, is increased and thus cost of a controller and size of a balancing system increases.

For performing said cell balancing, an accurate measurement of the voltage of each battery cell has to be performed in order to determine if a cell needs to be balanced.

When the balancing resistance is connected, current is circulating through the electrical wires and due to the resistance of the electrical wires, a tension drop is produced into said electrical wires.

If the length of the electrical wires extending between the cells and the voltage balancing unit is large, this can result in that the measurement of the cells voltage during the balancing process is erroneous. The error can be of 10 mV, four times the admissible error.

For avoiding said error, measurement of the voltage of the cells is accomplished by stopping the balancing process for avoiding the voltage drop in the electrical wires and at that time the measurement of the voltage in the cells is performed, then the balancing process is resumed so that all the cell groups are balanced. Measurement of the voltage of the cells is performed at intervals of, for instance 10 ms, and therefore in the cells that are being balanced, the switch opening and closing the balancing circuit is being opened and closed periodically to perform the measurement of the voltage, thus producing noise generation due to the commutations of current and also reducing the efficiency of the balancing.

FR2998729 discloses a method that involves activating or deactivating balancing of a cell by a balancing circuit according to the value of a signal (Ci, eq) of a command. A value (Ui) of voltage (Vi) at a set of boundaries of each cell is determined by measurement of the voltage at a set of boundaries of the circuit. A value of each resistance of individual electric wire (200) is calculated according to the sum of individual resistances of two wires, and voltage of the cell is calculated according to all the values of resistances of individual wires calculated at the preceding stage.

**SUMMARY OF THE INVENTION**

The object of this invention is a method and a system allowing the compensation of the measurement error of the voltage of the cells due to the voltage drop produced in the electrical wires, without the need to disconnect the balancing process during the measurement of the voltage in the cells.

The invention is defined in the claims.

The battery pack balancing system of the invention comprises:

- a plurality of battery cells,
- a battery balancer connected to each battery cell having a resistance $R_B$ connected in parallel to the battery cell,
- a cell monitor configured to determine the voltage of each cell and to manage the battery balancer, the cell monitor and the cell being connected through an electrical wire having a resistance $R_C$,
- computing means configured to perform the steps of the method of the invention. The battery pack balancing method comprises a first step, named calibration step, in which the calculation of a coefficient for each electrical wire connecting the cell monitors and the battery cells is performed when the battery cells do neither provide nor receive energy, for instance, when the vehicle is started, before accelerating the vehicle or when the vehicle is stopped at a traffic light, by performing the following steps:

   ▪ connecting the battery balancer and measuring the cell voltage $V(n)$,
   ▪ disconnecting the battery balancer and measuring the cell voltage $V_0(n)$, ▪ calculating in the computing means the coefficient of the wire $R_C(to) / R_B(t_0) = (V_0-V)/V$,
   ▪ storing each coefficient $R_C/R_B$ in a memory module,
   ▪ measuring the temperature of the cell and storing it in the memory module. Ideally, the temperature of each cell would be measured, but alternatively, the temperature of two locations within a group of cells could be measured and an average is made.

The process can be made by firstly disconnecting the battery balancer and measuring the cell voltage $V_0(n)$ and afterwards, connecting the battery balancer and measuring the cell voltage $V(n)$ or firstly connecting the battery balancer and measuring the cell voltage $V(n)$ and afterwards disconnecting the battery balancer and measuring the cell voltage $V_0(n)$.

Subsequently, the balancing process is performed when it is required by a battery cell, according to the criteria, the balancing process comprises the following steps:

   ▪ measuring the battery cell voltage $V$ and the battery cell temperature $(t_1)$ when performing said balancing,
   ▪ updating in the computing means the electrical wire coefficient $R_C/R_B$ to the measured temperature by:

$$\bullet \quad R_C(t_1) = R_C(t_0) * (1 + \alpha_C \Delta t)$$

$$\bullet \quad R_B(t_1) = R_B(t_0) * (1 + \alpha_B \Delta t)$$

   ▪ calculating in the computing means the cell voltage $V_0$ by $(V_0-V)/V = R_C(t_1) / R_B(t_1)$.

Being $t_1$ the present temperature, to the calibration temperature and $\alpha_C$ and $\alpha_B$ the temperature coefficient of the Resistances $R_C$ and $R_B$.

## DESCRIPTION OF THE FIGURES

To complete the description and in order to provide for a better understanding of the invention, a set of drawings is provided. Said drawings form an integral part of the description and illustrate preferred embodiments of the invention. The drawings comprise the following figures.

Figure 1 shows an embodiment of an electric circuitry of the cell monitor and its connection a battery cell of the battery system.

Figure 2 shows an embodiment of the battery management system, a group of cell monitors and the related battery cells.

Figure 3 shows a flowchart of the calibration phase.

Figure 4 shows a flowchart of the operation phase.

Figure 5 shows a function diagram showing the relationship and functions among the battery management system, the cell monitor and the battery cell according to one embodiment of the invention.

**DETAILED DESCRIPTION OF THE INVENTION**

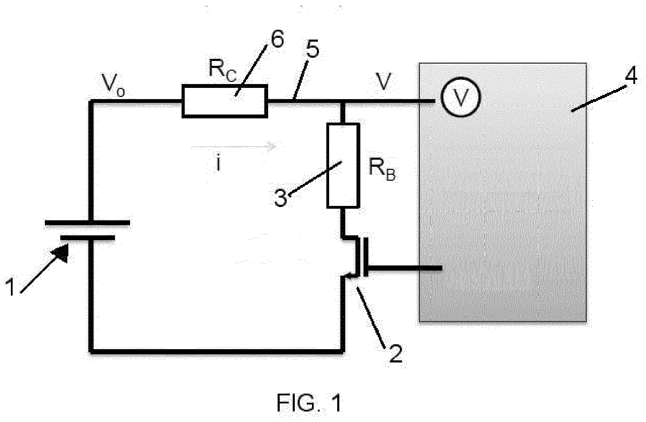

Figure 1 depicts an embodiment of an equivalent electronic circuitry connected to a battery cell (1) comprising:

  ◦ a cell monitor (4) that measures the voltage of the battery cell (1) and also activates a deactivates the balancing process,
  ◦ a balancing resistance $R_B$ (3) connected in parallel to the battery cell (1),
  ◦ the resistance of the electrical wires (5) $R_C$ (6) connecting the cell monitor (4) and the battery cell (1).

In the embodiment shown in Figure 1, $R_B$ (3) comprises the resistance of a transistor (2). A transistor (2) is connected to each battery cell (1) and can be turned on to bleed high battery cells (1) when necessary taking some charge current away from high battery cells (1).

$V_0$ is the battery cell (1) voltage and V is the measured battery cell (1) voltage. ($V_0$ - V) is the balancing error that is due to the balancing current through the resistance $R_C$ (6) of the electrical wires (5).

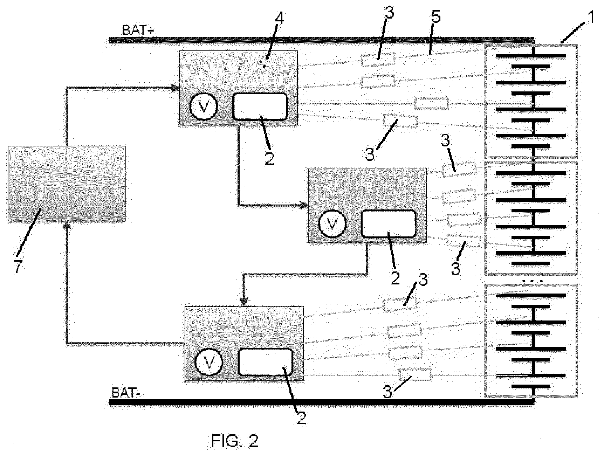

Figure 2 shows an embodiment in which a battery pack is depicted having a Battery Management System (7), a number *n* of cell monitors (4), each cell monitor (4) controlling a cell module comprising a group of battery cells (1), each cell monitor (4) connected to each battery cell (1) through a wire (5) for balancing each battery cell (1) and also for measuring the battery cell (1) voltage V.

According to the above, the method of the invention comprises two steps:

-   a calibration step, in which the calculation of a coefficient of each wire (5) connecting each battery cell (1) and its corresponding cell monitor (4) is calculated, and
-   a management step, in which the balancing of the battery cells (1) is performed.

As previously explained, the calibration step is performed when the battery cells (1) do neither provide nor receive energy, for instance when the vehicle is started. The following steps are performed:

  ▪ connecting the battery balancer (2) and measuring the battery cell (1) voltage V(n),
  ▪ disconnecting the battery balancer (2) and measuring the battery cell (1) voltage $V_0$(n), as there is no current it is assumed that $V_0$(n) = V(n),
  ▪ calculating the coefficient of each wire (5) through $R_C(t_0)$ / $R_B(t_0)$ = ($V_0$-V)/V For each battery cell (1) the voltage drop is $V_0$-V = i * Rc and the current of the battery cell (1) is i = V / $R_B$ such that the relationship between the voltage $V_0$ of the battery cell (1) and the measured voltage V is $R_C(t_0)$ / $R_B(t_0)$ = ($V_0$-V)/V.
  ▪ storing each coefficient $R_C(t_0)$ / $R_B(t_0)$ in a memory module,
  ▪ measuring the temperature of the battery cell (1) and storing it in the memory module.

The process can also be made by firstly disconnecting the battery balancer (2) and measuring the battery cell (1) voltage $V_0$(n) and afterwards connecting the battery balancer (2) and measuring the battery cell (1) voltage V(n) as the order of these two steps does not affect the measurement.

Therefore, the coefficient $R_C(t_0)$ / $R_B(t_0)$ of each wire (5) is representative of:

-   each electric wire (5), and
-   the relationship between the voltage $V_0$ of the battery cell (1) and the measured voltage V.

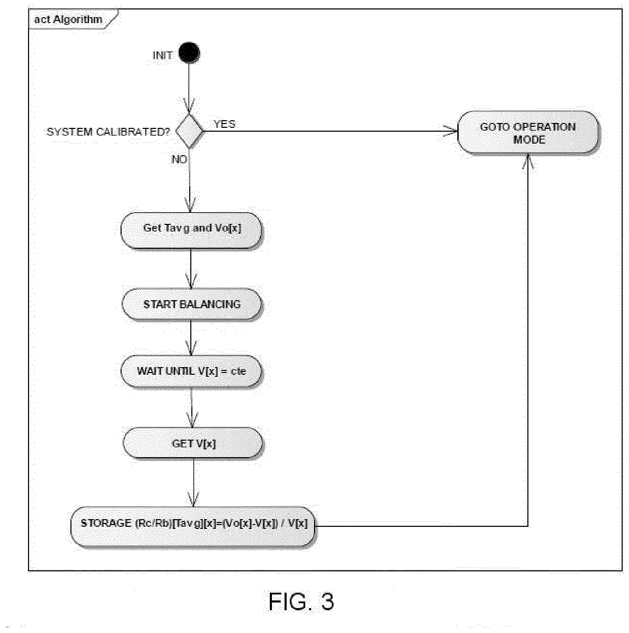

Figure 3 depicts an embodiment of the algorithm at the calibration step. If the system is not calibrated, it retrieves the temperature of the battery cell (1) and measures the voltage $V_0$, afterwards it starts the balancing process and retrieves the voltage V of the battery cell (1) when the voltage V is constant and finally, the relationship $R_C/R_B$ is storaged in the memory module.

At the operation step, a compensation of the electrical wire (5) coefficient with the temperature is performed. There is a direct relationship between the temperature of the battery cell (1) and the corresponding electrical wire (5) resistance. This relationship is based on the temperature coefficient of the material used in the battery cell (1) element.

$$R_C(t_1)=R_C(t_0) * (1 + \alpha_C \Delta t)$$

$$R_B(t_1)=R_B(t_0) * (1 + \alpha_B \Delta t)$$

where

$\alpha_C$ is the temperature coefficient of $R_C$ (6), and
$\alpha_B$ is the temperature coefficient of $R_B$ (3).

Therefore a calculation of the coefficient $R_C/R_B$ compensated by the current temperature is performed.
Finally, for the following measurement, the real cell (1) voltage $V_0$ is calculated through the formula:

$$(V_0-V)/V = R_C(t_1)/R_B(t_1).$$

Additionally, the voltage limits of the battery cells (1) are also calculated, overvoltage and low voltage. Most cell monitors (4) have an alarm that, if a battery cell (1) is outside safe limits, is activated. These limits have to be sent to the cell monitor (4). In order to avoid false activations of the alarm or surcharged of the battery cells (1), said limits are calculated and sent to the cell monitor (4) by the following formulae:

$$OV_{Limit}[X] = OV_{Threshold} + \left(\frac{R_C}{R_B}\Big|T_{avg0}\right)[x]\frac{1 + \alpha_C(\Delta T)}{1 + \alpha_B(\Delta T)}V[X]$$

$$UV_{Limit}[X] = UV_{Threshold} + \left(\frac{R_C}{R_B}\Big|T_{avg0}\right)[x]\frac{1 + \alpha_C(\Delta T)}{1 + \alpha_B(\Delta T)}V[X]$$

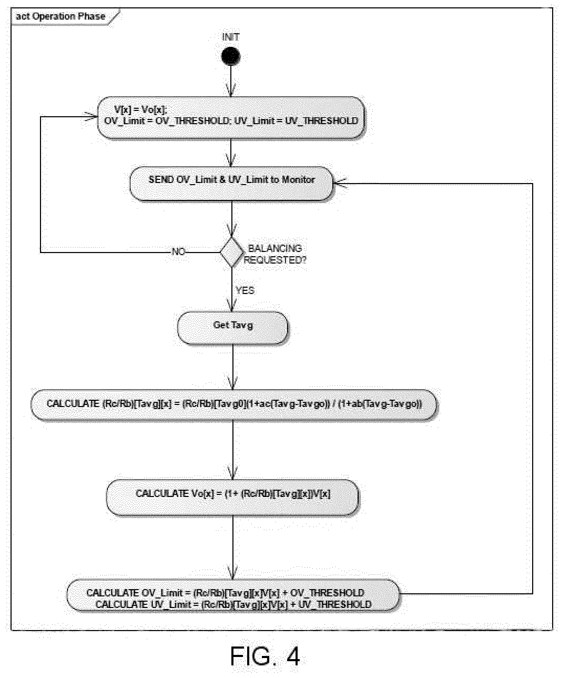

Figure 4 discloses an embodiment of the operation steps. If the balancing is performed, the temperature of the battery cells (1) is requested and the relationship $R_C(t_1)/R_B(t_1)$ and thus $V_0$ is calculated. The voltage limits of the battery cells (1) are also calculated and sent to the monitor cell (4).

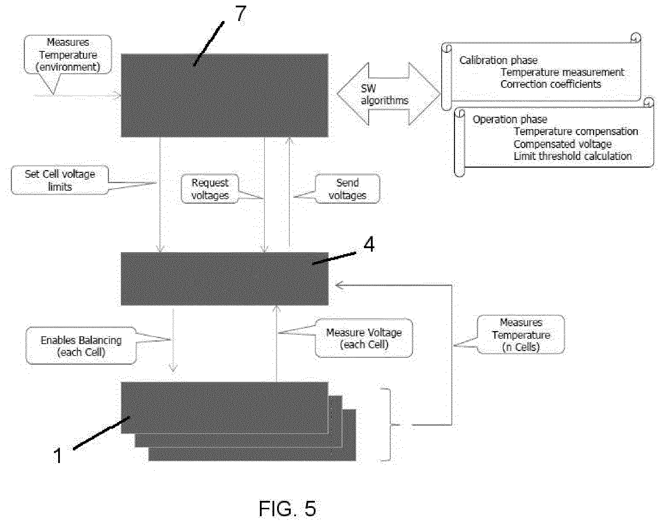

Figure 5 discloses a battery management system (7) managing a cell monitor (4). The battery management system (7) comprises computing means of the calibration phase and of the operation phase and therefore may instruct the cell monitor (4) when to perform the balancing of the battery cells (1). Another alternative is that the cell monitor (4) decides, according to the data receive from the battery management system (7), when to perform the balancing of the battery cells (1).
In the specified embodiment, the battery management system (7) performs the algorithms related to the calibration phase and the operation phase, i.e., it calculates the correction coefficients, the compensated voltage and the limit threshold. The cell voltage limits are sent to the cell monitors (4) for performing the balancing of the battery cells (1). The cell monitors (4) measure the voltages and temperatures from the battery cells (1) and send the information to the battery management system (7).

## Claims

1. A battery pack balancing method for a vehicle, the battery pack comprising:

   ◦ a plurality of battery cells (1),
   ◦ a battery balancer (2) connected to each battery cell (1) having a resistance $R_B$ (3) connected in parallel to the battery cell (1),
   ◦ a cell monitor (4) which measures the voltage of each battery cell (1) and manages the battery balancer (2), the cell monitor (4) and the battery cell (1) being connected through an electrical wire (5) having a resistance $R_C$ (6),
   ◦ computing means,

   **characterised in that** the balancing method is performed by the computing means and comprises the following steps:

   - a first calibration step modelling each electrical wire (5) connecting the cell monitors (4) and the battery cells (1) and calculating a coefficient for each electrical wire (5) when the battery cells (1) do neither provide nor receive energy, the modelling comprising the following steps:

- connecting the battery balancer (2) and measuring the battery cell (1) voltage V(n),
- disconnecting the battery balancer (2) and measuring the battery cell (1) voltage $V_0(n)$,
- calculating the coefficient of each wire (5) through

$$R_C(t_0) / R_B(t_0) = (V_0-V)/V,$$

- storing each coefficient $R_C(t_0) / R_B(t_0)$ in a memory module,
- measuring the temperature of the battery cell (1) and storing it in the memory module;

- a subsequent management step performing a balancing process of the battery cells (1) when a battery cell (1) is unbalanced and compensating an error of voltage measurement by the following steps:

- measuring the battery cell (1) voltage V and the battery cell (1) temperature $t_1$ when performing said balancing,
- updating the electrical wire (5) coefficient $R_C/R_B$ to the measured temperature ($t_1$) of the battery cell (1) by:

- $R_C(t_1) = R_C(t_0) * (1 + \alpha_C \Delta t)$

- $R_B(t_1) = R_B(t_0) * (1 + \alpha_B \Delta t)$

wherein $\alpha_C$ and $\alpha_B$ are temperature coefficients of the resistances $R_C$ and $R_B$,
- calculating the battery cell (1) voltage $V_0$ by $(V_0-V)/V = R_C(t_1) /R_B(t_1)$.

2. A battery pack balancing method for a vehicle, according to claim 1, wherein it comprises the following additional steps:

- calculating voltage limits of the battery cell (1) in the computing means by:

$$OV_{Limit}[X] = OV_{Threshold} + \left(\frac{R_C}{R_B}\Big|T_{avg0}\right)[x]\frac{1 + \alpha_C(\Delta T)}{1 + \alpha_B(\Delta T)}V[X]$$

$$UV_{Limit}[X] = UV_{Threshold} + \left(\frac{R_C}{R_B}\Big|T_{avg0}\right)[x]\frac{1 + \alpha_C(\Delta T)}{1 + \alpha_B(\Delta T)}V[X]$$

being $OV_{Limit}$ the overvoltage limit, $UV_{Limit}$ the lowvoltage limit, $OV_{Threshold}$ the overvoltage threshold and $UV_{Threshold}$ the lowvoltage threshold,
- sending the calculated voltage limits to the cell monitor (4).

3. A battery pack balancing method for a vehicle, according to any preceding claim, wherein the battery pack additionally comprises a battery management system (7) in connection with a plurality of cell monitors (4) being the computing means located in said battery management system (7).

4. A battery pack balancing method for a vehicle, according to claim 3 when dependent on claim 2, wherein the voltage limits of the battery cells (1) are calculated at the battery management system (7) and sent to the cell monitor (4).

5. A battery pack balancing method for a vehicle, according to claim 3 or 4, wherein the cell monitor (4) measures the voltage and temperature of the battery cells (1) and send said information to the battery management system (7).

6. A battery pack balancing method for a vehicle, according to any preceding claim 3 to 5, wherein the battery management system (7) decides when to perform the balancing of the battery cells (1) and instructs the cell monitor (4) to perform said balancing.

7. A battery pack balancing method for a vehicle, according to any preceding claim 3 to 5, wherein the cell monitor (4) decides when to perform the balancing of the battery cells (1) according to the data received from the battery management system (7).

8. A battery pack balancing system for a vehicle, comprising:

   ◦ a plurality of battery cells (1),
   ◦ a battery balancer (2) connected to each battery cell (1) having a resistance $R_B$ (3) connected in parallel to the battery cell (1),
   ◦ a cell monitor (4) configured to measure the voltage of each battery cell (1) and to manage the battery balancer (2), the cell monitor (4) and the battery cell (1) connected through an electrical wire (5) having a resistance $R_C$ (6),
   ◦ computing means,

   **characterised in that** the computing means is configured:

   ◦ to firstly performing a calibration step modelling each electrical wire (5) connecting the cell monitors (4) and the battery cells (1) and to calculate a coefficient for each electrical wire (5) when the battery cells (1) do neither provide nor receive energy to

   ▪ connect the battery balancer (2) and measure the battery cell (1) voltage $V(n)$,
   ▪ disconnect the battery balancer (2) and measure the battery cell (1) voltage $V_0(n)$,
   ▪ calculate the coefficient of each wire (5) through $R_C(t_0) / R_B(t_0) = (V_0 - V)/V$,
   ▪ store each coefficient $R_C(t_0) / R_B(t_0)$ in a memory module,
   ▪ measure the temperature of the battery cell (1) and to store it in the memory module;

   ◦ to subsequently performing a management step by a balancing process of the battery cells (1) when a battery cell (1) is unbalanced and compensating an error of voltage measurement by

   ▪ measuring the battery cell (1) voltage $V_0$ and the battery cell (1) temperature $t_1$ when performing said balancing,
   ▪ updating the electrical wire (5) coefficient $R_C/R_B$ to the measured temperature of the battery cell (1) by:

   $$\circ \quad R_C(t_1) = R_C(t_0) * (1 + \alpha_C \Delta t)$$

   $$\circ \quad R_B(t_1) = R_B(t_0) * (1 + \alpha_B \Delta t)$$

   wherein $\alpha_C$ and $\alpha_B$ are temperature coefficients of the resistances $R_C$ and $R_B$,
   ▪ calculating the cell (1) voltage $V$ by $(V_0 - V)/V = R_C(t_1) /R_B(t_1)$.

9. A battery pack balancing system, according to claim 8, comprising additionally a battery management system (7) managing a plurality of cell monitors (4), the battery management system (7) comprising the computing means.

**Patentansprüche**

1. Batteriepackausgleichsverfahren für ein Fahrzeug, wobei der Batteriepack Folgendes umfasst:

   ◦ eine Vielzahl von Batteriezellen (1),
   ◦ einen mit jeder Batteriezelle (1) verbundenen Batterieausgleicher (2), der einen Widerstand $R_B$ (3) aufweist, der parallel mit der Batteriezelle (1) verbunden ist,
   ◦ einen Zellenmonitor (4), der die Spannung jeder Batteriezelle (1) misst und verwaltet, wobei der Batterieausgleicher (2), der Zellmonitor (4) und die Batteriezelle (1) durch einen elektrischen Draht (5) verbunden sind, der einen Widerstand Rc (6) aufweist,
   ◦ Rechenmittel,

**dadurch gekennzeichnet, dass** das Ausgleichsverfahren durch die Rechenmittel durchgeführt wird und die folgenden Schritte umfasst:

- einen ersten Eichschritt, bei dem jeder elektrische Draht (5), der die Zellmonitore (4) und die Batteriezellen (1) verbindet, modelliert und ein Koeffizient für jeden elektrischen Draht (5) berechnet wird, wenn die Batteriezellen (1) Energie weder bereitstellen noch empfangen, wobei das Modellieren die folgenden Schritte umfasst:

  - Verbinden des Batterieausgleichers (2) und Messen der Spannung V(n) der Batteriezelle (1),
  - Trennen des Batterieausgleichers (2) und Messen der Spannung $V_0(n)$ der Batteriezelle (1),
  - Berechnen des Koeffizienten jedes Drahtes (5) mit $R_C(t_0)/R_B(t_0) = (V_0-V)/V$,
  - Speichern jedes Koeffizienten $R_C(t_0)/R_B(t_0)$ in einem Speichermodul,
  - Messen der Temperatur der Batteriezelle (1) und deren Speichern im Speichermodul;

- einen nachfolgenden Verwaltungsschritt, bei dem ein Ausgleichsvorgang der Batteriezellen (1) durchgeführt wird, wenn eine Batteriezelle (1) unausgeglichen ist, und ein Fehler der Spannungsmessung durch die folgenden Schritte kompensiert wird:

  - Messen der Spannung V der Batteriezelle (1) und die Temperatur t1 der Batteriezelle (1), wenn das Ausgleichen durchgeführt wird,
  - Aktualisieren des Koeffizienten $R_C/R_B$ des elektrischen Drahtes (5) auf die Messtemperatur ($t_1$) der Batteriezelle (1) durch:

$$R_C(t_1) = R_C(t_0) * (1 + \alpha_C\Delta t)$$

$$R_B(t_1) = R_B(t_0) * (1 + \alpha_B\Delta t)$$

wobei $\alpha_C$ und $\alpha_B$ Temperaturkoeffizienten der Widerstände $R_C$ und $R_B$ sind,
  - Berechnen der Spannung $V_0$ der Batteriezelle (1) durch $(V_0-V)/V = R_C(t_1)/ R_B(t1)$.

2. Batteriepackausgleichsverfahren für ein Fahrzeug nach Anspruch 1, wobei es die folgenden zusätzlichen Schritte umfasst:

- Berechnen der Spannungsgrenzen der Batteriezelle (1) in den Rechenmitteln durch:

$$OV_{Grenze}[X] = OV_{Schwelle} + \left(\frac{R_C}{R_B}\Big|T_{avg0}\right)[x]\frac{1 + \alpha_C(\Delta T)}{1 + \alpha_B(\Delta T)}V[X]$$

$$UV_{Grenze}[X] = UV_{Schwelle} + \left(\frac{R_C}{R_B}\Big|T_{avg0}\right)[x]\frac{1 + \alpha_C(\Delta T)}{1 + \alpha_B(\Delta T)}V[X]$$

wobei $OV_{Grenze}$ die Überspannungsgrenze, $UV_{Grenze}$ die Niederspannungsgrenze, $OV_{Schwelle}$ die Überspannungsschwelle und $UV_{Schwelle}$ die Niederspannungsschwelle ist,
- Senden der berechneten Spannungsgrenzen an den Zellmonitor (4).

3. Batteriepackausgleichsverfahren für ein Fahrzeug nach einem der vorstehenden Ansprüche, wobei der Batteriepack zusätzlich dazu eine Batterieverwaltungssystem (7) in Verbindung mit einer Vielzahl von Zellmonitoren (4) umfasst, die die in dem Batterieverwaltungssystem (7) angeordneten Rechenmittel sind.

4. Batteriepackausgleichsverfahren für ein Fahrzeug nach Anspruch 3 in Abhängigkeit von Anspruch 2, wobei die Spannungsgrenzen der Batteriezellen (1) an dem Batterieverwaltungssystem (7) berechnet und an den Zellmonitor (4) gesendet werden.

5. Batteriepackausgleichsverfahren für ein Fahrzeug nach Anspruch 3 oder 4, wobei der Zellmonitor (4) die Spannung und die Temperatur der Batteriezellen (1) misst und diese Informationen an das Batterieverwaltungssystem (7) sendet.

6. Batteriepackausgleichsverfahren für ein Fahrzeug nach einem der Ansprüche 3 bis 5, wobei das Batterieverwaltungssystem (7) entscheidet, wann das Ausgleichen der Batteriezellen (1) durchzuführen ist, und den Zellmonitor (4) anweist, das Ausgleichen durchzuführen.

7. Batteriepackausgleichsverfahren für ein Fahrzeug nach einem der Ansprüche 3 bis 5, wobei der Zellmonitor (4) anhand der von dem Batterieverwaltungssystem (7) empfangenen Daten entscheidet, wann das Ausgleichen der Batteriezellen (1) durchzuführen ist.

8. Batteriepackausgleichssystem für ein Fahrzeug, umfassend:

   ◦ eine Vielzahl von Batteriezellen (1),
   ◦ einen mit jeder Batteriezelle (1) verbundenen Batterieausgleicher (2), der einen Widerstand $R_B$ (3) aufweist, der parallel mit der Batteriezelle (1) verbunden ist,
   ◦ einen Zellenmonitor (4), der dazu ausgelegt ist, die Spannung jeder Batteriezelle (1) zu messen und zu verwalten, wobei der Batterieausgleicher (2), der Zellmonitor (4) und die Batteriezelle (1) durch einen elektrischen Draht (5) verbunden sind, der einen Widerstand $R_C$ (6) aufweist,
   ◦ Rechenmittel,

   **dadurch gekennzeichnet, dass** die Rechenmittel dazu ausgelegt sind:

   ◦ zunächst einen Eichschritt durchzuführen, bei dem jeder elektrische Draht (5), der die Zellmonitore (4) und die Batteriezellen (1) verbindet, modelliert wird, und einen Koeffizienten für jeden elektrischen Draht (5) zu berechnen, wenn die Batteriezellen (1) Energie weder bereitstellen noch empfangen, um:

   ▪ den Batterieausgleicher (2) zu verbinden und die Spannung V(n) der Batteriezelle (1) zu messen,
   ▪ den Batterieausgleicher (2) zu trennen und die Spannung Vo(n) der Batteriezelle (1) zu messen,
   ▪ den Koeffizienten jedes Drahtes (5) mit $R_C(t_0)/R_B(t_0) = (V_0-V)/V$ zu berechnen,
   ▪ jeden Koeffizienten $RC(t_0)/RB(t_0)$ in einem Speichermodul zu speichern,
   ▪ die Temperatur der Batteriezelle (1) zu messen und sie in dem Speichermodul zu speichern;

   ◦ nachfolgend einen Verwaltungsschritt durch einen Ausgleichsvorgang der Batteriezellen (1) durchzuführen, wenn eine Batteriezelle (1) unausgeglichen ist, und einen Fehler der Spannungsmessung zu kompensieren durch:

   ▪ Messen der Spannung V der Batteriezelle (1) und die Temperatur $t_1$ der Batteriezelle (1), wenn das Ausgleichen durchgeführt wird,
   ▪ Aktualisieren des Koeffizienten $R_C/R_B$ des elektrischen Drahtes (5) auf die Messtemperatur ($t_1$) der Batteriezelle (1) durch:

   $$\circ \quad R_C(t_1) = R_C(t_0) * (1 + \alpha_C \Delta t)$$

   $$\circ \quad R_B(t_1) = R_B(t_0) * (1 + \alpha_B \Delta t)$$

   wobei $\alpha_C$ und $\alpha_B$ Temperaturkoeffizienten der Widerstände $R_C$ und $R_B$ sind,
   ▪ Berechnen der Spannung V der Zelle (1) durch $(V_0-V)/V = R_C(t_1)/R_B(t_1)$.

9. Batteriepackausgleichssystem nach Anspruch 8, umfassend zusätzlich dazu ein Batterieverwaltungssystem (7), dass eine Vielzahl von Zellmonitoren (4) verwaltet, wobei das Batterieverwaltungssystem (7) die Rechenmittel umfasst.

**Revendications**

1. Procédé d'équilibrage de bloc-batterie pour un véhicule, le bloc-batterie comprenant :

   ○ une pluralité d'éléments de batterie (1),
   ○ un équilibreur de batterie (2) raccordé à chaque élément de batterie (1) ayant une résistance $R_B$ (3) raccordée en parallèle à l'élément de batterie (1),
   ○ un moniteur d'élément (4) qui mesure la tension de chaque élément de batterie (1) et gère l'équilibreur de batterie (2), le moniteur d'élément (4) et l'élément de batterie (1) étant raccordés via un fil électrique (5) ayant une résistance Rc (6)
   ○ un outil de calcul,

   **caractérisé en ce que** le procédé d'équilibrage est réalisé par l'outil de calcul et comprend les étapes suivantes :

   - une première étape de calibrage modélisant chaque fil électrique (5) raccordant les moniteurs d'élément (4) et les éléments de batterie (1) et calculant un coefficient pour chaque fil électrique (5) lorsque les éléments de batterie (1) ne fournissent ni ne reçoivent de l'énergie, la modélisation comprenant les étapes suivantes :

     ■ raccorder l'équilibreur de batterie (2) et mesurer la tension V(n) de l'élément de batterie (1),
     ■ déconnecter l'équilibreur de batterie (2) et mesurer la tension Vo(n) de l'élément de batterie (1),
     ■ calculer le coefficient de chaque fil (5) via $R_C(t_0)/R_B(t_0) = (V_0-V)/V$,
     ■ sauvegarder chaque coefficient $R_C(t_0)/R_B(t_0)$ dans un module de mémoire,
     ■ mesurer la température de l'élément de batterie (1) et la sauvegarder dans le module de mémoire ;

   - une étape de gestion ultérieure réalisant mettant en oeuvre un procédé d'équilibrage des éléments de batterie (1) lorsqu'un élément de batterie (1) n'est pas équilibré et compensant une erreur de mesure de tension par les étapes suivantes :

     ■ mesurer la tension V de l'élément de batterie (1) et la température $t_1$ de l'élément de batterie (1) lors de la réalisation dudit équilibrage,
     ■ actualiser le coefficient $R_C/R_B$ de fil électrique (5) à la température ($t_1$) mesurée de l'élément de batterie (1) par :

     $$\bullet \quad R_C(t_1) = R_C(t_0) * (1 + \alpha_C \Delta t)$$

     $$\bullet \quad R_B(t_1) = R_B(t_0) * (1 + \alpha_B \Delta t)$$

     où $\alpha_C$ et $\alpha_B$ sont des coefficients de température des résistances $R_C$ et $R_B$.
     ■ calculer la tension $V_0$ de l'élément de batterie (1) par $(V_0-V)/V = R_C(t_1)/ R_B(t_1)$.

2. Procédé d'équilibrage de bloc-batterie pour un véhicule, selon la revendication 1, dans lequel sont incluses les étapes supplémentaires suivantes :

   - calculer les limites de tension de l'élément de batterie (1) dans l'outil de calcul par :

   $$OV_{Limit}[X] = OV_{Threshold} + \left(\frac{R_C}{R_B}\Big|T_{avg0}\right)[x]\frac{1 + \alpha_C\,(\Delta T)}{1 + \alpha_B\,(\Delta T)}V[X]$$

   $$UV_{Limit}[X] = UV_{Threshold} + \left(\frac{R_C}{R_B}\Big|T_{avg0}\right)[x]\frac{1 + \alpha_C\,(\Delta T)}{1 + \alpha_B\,(\Delta T)}V[X]$$

   étant $OV_{Limit}$ la limite de surtension, $UV_{Limit}$ la limite de basse tension, $OV_{Threshold}$ le seuil de surtension et $UV_{Threshold}$ le seuil de basse tension,

- envoyer les limites de tension calculées au moniteur d'élément (4).

3.  Procédé d'équilibrage de bloc-batterie pour un véhicule, selon l'une des revendications précédentes, dans lequel le bloc-batterie comprend en outre un système de gestion de batterie (7) en connexion avec une pluralité de moniteurs d'élément (4) l'outil de calcul étant situé dans ledit système de gestion de batterie (7).

4.  Procédé d'équilibrage de bloc-batterie pour un véhicule, selon la revendication 3 lorsqu'elle est dépendante de la revendication 2, dans lequel les limites de tension des éléments de batterie (1) sont calculées dans le système de gestion de batterie (7) et envoyées au moniteur d'élément (4).

5.  Procédé d'équilibrage de bloc-batterie pour un véhicule, selon la revendication 3 ou 4, dans lequel le moniteur d'élément (4) mesure la tension et la température des éléments de batterie (1) et envoie lesdites informations au système de gestion de batterie (7).

6.  Procédé d'équilibrage de bloc-batterie pour un véhicule, selon l'une des revendications 3 à 5 précédentes, dans lequel le système de gestion de batterie (7) décide à quel moment réaliser l'équilibrage des éléments de batterie (1) et indique au moniteur d'élément (4) de réaliser ledit équilibrage.

7.  Procédé d'équilibrage de bloc-batterie pour un véhicule, selon l'une des revendications 3 à 5 précédentes, dans lequel le moniteur d'élément (4) décide à quel moment réaliser l'équilibrage des éléments de batterie (1) en fonction des données reçues du système de gestion de batterie (7).

8.  Système d'équilibrage de bloc-batterie pour un véhicule, comprenant :

    ◦ une pluralité d'éléments de batterie (1),
    ◦ un équilibreur de batterie (2) raccordé à chaque élément de batterie (1) ayant une résistance $R_B$ (3) raccordée en parallèle à l'élément de batterie (1),
    ◦ un moniteur d'élément (4) configuré pour mesurer la tension de chaque élément de batterie (1) et pour gérer l'équilibreur de batterie (2), le moniteur d'élément (4) et l'élément de batterie (1) raccordés via un fil électrique (5) ayant une résistance $R_C$ (6),
    ◦ un outil de calcul,

    **caractérisé en ce que** l'outil de calcul est configuré :

    ◦ pour réaliser d'abord une étape de calibrage modélisant chaque fil électrique (5) raccordant les moniteurs d'élément (4) et les éléments de batterie (1) et pour calculer un coefficient pour chaque fil électrique (5) lorsque les éléments de batterie (1) ne fournissent ni ne reçoivent de l'énergie pour

        ▪ raccorder l'équilibreur de batterie (2) et mesurer la tension V(n) de l'élément de batterie (1),
        ▪ déconnecter l'équilibreur de batterie (2) et mesurer la tension $V_0(n)$ de l'élément de batterie (1),
        ▪ calculer le coefficient de chaque fil (5) via $R_C(t_0)/R_B(t_0) = (V_0-V)/V$,
        ▪ sauvegarder chaque coefficient $R_C(t_0)/R_B(t_0)$ dans un module de mémoire,
        ▪ mesurer la température de l'élément de batterie (1) et la sauvegarder dans le module de mémoire ;

    ◦ pour réaliser ensuite une étape de gestion par un procédé d'équilibrage des éléments de batterie (1) lorsqu'un élément de batterie (1) n'est pas équilibré et compenser une erreur de mesure de tension en

        ▪ mesurant la tension $V_0$ de l'élément de batterie (1) et la température $t_1$ de l'élément de batterie (1) lors de la réalisation dudit équilibrage,
        ▪ actualisant le coefficient $R_C/R_B$ de fil électrique (5) à la température mesurée de l'élément de batterie (1) par :

$$\circ \quad R_C(t_1) = R_C(t_0) * (1 + \alpha_C \Delta t)$$

$$\circ \quad R_B(t_1) = R_B(t_0) * (1 + \alpha_B \Delta t)$$

où $\alpha_C$ et $\alpha_B$ sont des coefficients de température des résistances $R_C$ et $R_B$,

■ calculant la tension V de l'élément de batterie (1) par $(V_0-V)/V = R_C(t_1)/ R_B(t_1)$.

9. Système d'équilibrage de bloc-batterie, selon la revendication 8, comprenant en outre un système de gestion de batterie (7) gérant une pluralité de moniteurs d'élément (4), le système de gestion de batterie (7) comprenant l'outil de calcul.

FIG. 1

FIG. 2

act Algorithm

INIT ●

SYSTEM CALIBRATED? ◇ —— YES ——→ GOTO OPERATION MODE

NO

Get Tavg and Vo[x]

START BALANCING

WAIT UNTIL V[x] = cte

GET V[x]

STORAGE (Rc/Rb)[Tavg][x]=(Vo[x]-V[x]) / V[x]

FIG. 3

FIG. 4

FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- FR 2998729